# EUROPEAN PATENT APPLICATION

(11) **EP 4 703 737 A1**
(43) Date of publication of application: **04.03.2026**
(21) Application number: 25198291.4
(22) Date of filing: 26.08.2025
(51) Int. Cl.: G01R 19/25, G01R 21/133, G01R 22/06

(54) **ELECTRICAL PARAMETER MEASURING DEVICE**

(30) Priority: 26.08.2024 BR 102024017481
(71) Applicant: Solfacil Energia Solar Tecnologia e Servicos Financeiros Ltda., 05408-003 São Paulo (BR)
(72) Inventor: De Souza Alves, Marcus Vininius, 05408-003 Sao Paulo (BR)
(74) Representative: Dehns

(57) **Abstract**

The present invention relates to a electrical parameters measuring device (100) of an electrical installation, the device comprising:
- a control unit;
- electromagnetic current and voltage sensors (120) associated with the electrical installation, adapted to transform the sensed current and voltage into electrical signals that can be processed by the measuring device (100); and
- a data storage memory
the control unit being adapted to:
measure electrical parameters of the electrical installation based on the acquisition of processable electrical signals; and
store a history of measurements in data storage memory.

## Description

### FIELD OF THE INVENTION

The present invention relates to a electrical parameters measuring device of an electrical installation. In particular, the device of the present invention is capable of storing electrical data, performing electrical data telemetry and reporting them to a control center.

### BACKGROUND OF THE INVENTION

Electrical parameter measuring devices are devices used by electricity distributors to record consumers' electricity consumption, allowing them to differentiate usage according to the applicable time zones and tariffs. Using sensors and algorithms, these devices not only measure the amount of electricity consumed but also record the exact times of use, allowing for the application of differentiated tariffs for peak periods (i.e., high electricity consumption) and off-peak periods. This encourages consumers to adjust their consumption habits, resulting in better load distribution and greater energy efficiency.

The use cases for electrical parameter measurement devices are varied and include both residential and commercial and industrial environments. In homes, these devices help reduce electricity consumption costs by encouraging the use of appliances during peak hours. In commercial environments, such as offices and stores, they enable more efficient management of electrical appliances, such as lighting and air conditioning systems, aligning consumption during peak hours. In the industrial sector, where electricity consumption is significantly higher, these devices enable the optimization of production processes and the reduction of peak demand, contributing to the sustainability and competitiveness of operations. In short, electrical parameter measurement devices are essential tools for the intelligent and economical management of electricity, benefiting both distributors and end consumers.

However, a disadvantage of prior art electrical parameter measurement devices is their installation and configuration, which can be complex, requiring advanced technical knowledge and hindering adoption by residential users and small businesses. A Harvard Business Review survey indicates that 70% of these technology projects fail due to implementation complexity.

Furthermore, existing electrical parameter measurement devices do not assess power quality parameters such as harmonics and power factor, which can negatively affect the operation of electrical appliances. Studies show that harmonic distortions can reduce equipment lifespan by up to 30%.

Another shortcoming of the prior art is that most existing electrical parameter measurement devices have limited communication capabilities, generally restricted to local connections such as Wi-Fi, hindering remote monitoring and integration with smart management systems.

Furthermore, prior art electrical parameter measuring devices do not have independent storage memory, limiting the ability to record and analyze detailed historical data, which may be lost in the event of Wi-Fi connection instability.

Prior art electrical parameter measuring devices are also designed to operate in specific electrical networks, for example, in single-phase, two-phase, or three-phase electrical networks, which limits the applicability and adaptability of these devices to different electrical network configurations.

Furthermore, current state-of-the-art electrical parameter measuring devices are not suitable for withstanding inclement weather, reducing their useful life when installed in installations exposed to adverse weather conditions.

Therefore, there is a clear need for an electrical parameter measuring device with simplified installation and configuration for a wider audience, with power quality measurement functionalities, multiple communication and data transmission options, and internal storage that allows for the recording of historical data to prevent information loss and enable later analysis.

### DESCRIPTION OF THE INVENTION

The general objective of the present invention is to provide an intelligent electrical parameter measuring device capable of accurately measuring the electrical parameters of an electrical installation, transmitting data via different communication media to a control center, locally storing the acquired data, and providing greater flexibility and simplification in its installation and configuration.

A particular objective of the present invention is to reduce the complexity of installing and configuring the electrical parameter measuring device by providing the device with a color graphic display, buttons, and LEDs. The device is also operable via a mobile application, making it accessible to a wider audience and facilitating commissioning and maintenance of the device.

Another particular objective of the present invention is to provide the device with means for measuring multiple electrical parameters of an electrical network, including harmonic distortions and power factor, allowing the device to identify and correct electrical faults, protecting electrical equipment powered by the electrical network and improving the efficiency of the electrical network.

Another particular objective of the present invention is to reduce limitations in data communication by providing the device with multiple communication options, such as cellular network, long-range radio, and Wi-Fi, ensuring flexible and robust data transmission, enabling continuous and remote monitoring of the electrical grid.

It is also a particular objective of the present invention to provide the device with a machine-readable, non-volatile data storage memory that allows the storage of a data history of electrical grid parameters obtained by the device, facilitating detailed analysis and identification of energy consumption and generation patterns, in addition to storing data used for anti-fraud purposes, such as geolocation by Global Navigation Satellite System (GNSS) and human presence near the device.

Another particular objective of the present invention is to provide a compact device designed to operate in single-phase, two-phase, and three-phase electrical networks, automatically adapting to the installation environment, increasing its versatility and applicability in various electrical configurations through adjustable current sensors and flexible hardware configurations.

Furthermore, it is also a particular objective of the present invention to provide a device with IP65 protection rating, expanding its application possibilities and ensuring durability and reliability in adverse conditions.

One or more of the aforementioned objectives of the present invention, among others, is achieved by means of a electrical parameters measuring device of an electrical installation that comprises:
- a control unit;
- electromagnetic current and voltage sensors associated with the electrical installation, adapted to transform the sensed current and voltage into electrical signals that can be processed by the measuring device; and
- a data storage memory;
- the control unit being adapted to:
- measure electrical parameters of the electrical installation based on the acquisition of processable electrical signals; and
- store a history of measurements in the data storage memory.

### BRIEF DESCRIPTION OF THE DRAWINGS

The objectives, technical effects and advantages of the present invention will be apparent to those skilled in the art from the following detailed description that makes reference to the attached figures, which illustrate exemplary, but not limiting, embodiments of the claimed object:
- Figure 1 illustrates one embodiment of the electrical parameter measuring device 100;
- Figure 2 illustrates another embodiment of the electrical parameter measuring device 100; and

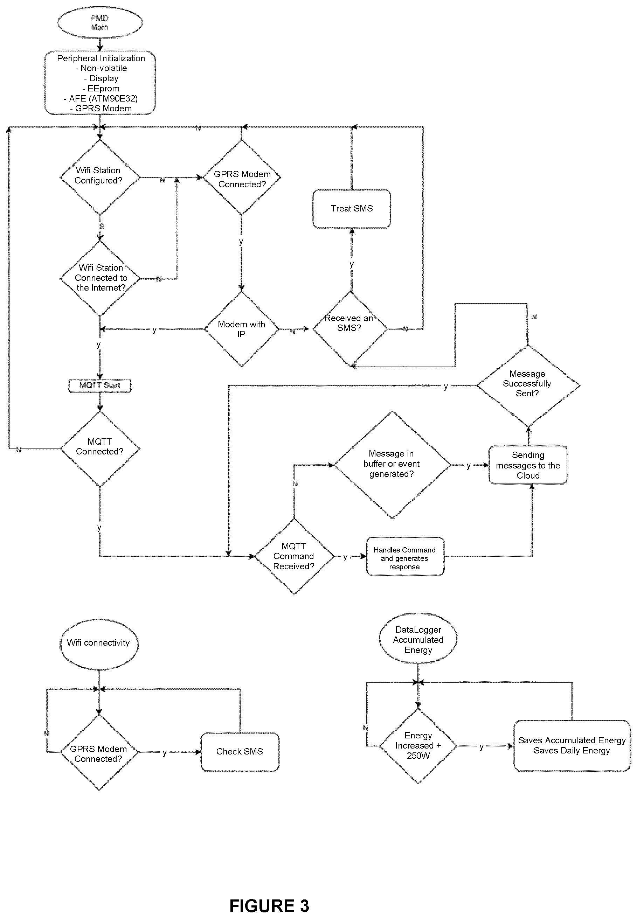

- Figure 3 presents a flowchart representing the initialization process of the electrical parameter measuring device 100.

### DESCRIPTION OF THE EMBODIMENTS OF THE INVENTION

Before any embodiments of the present invention are explained in detail, it should be understood that the invention is not limited, in its application, to the construction details and arrangement of components demonstrated in the following description by references such as "in a preferred embodiment" and "in an alternative embodiment" or illustrated in the accompanying drawings. The invention may comprise other embodiments and be practiced or carried out in various ways including combinations (even if not explicitly described) of features described in different embodiments. It should also be understood that the phraseology and terminology used in this descriptive report of the present invention are for descriptive purposes and should not be considered limiting.

Thus, aspects of phrases such as "in a preferred embodiment" and "in alternative embodiments" in various places throughout this specification are not necessarily referring to the same embodiment of the presently claimed invention. Furthermore, particular features, structures, materials, or characteristics may be combined in any suitable manner in one or more embodiments. All of the various embodiments, aspects, and options disclosed herein may be combined in all variations, regardless of whether such features or elements are expressly combined in a specific embodiment description herein. This presently claimed invention is intended to be read holistically, such that any separable features or elements of the disclosed invention, in any of its various aspects and embodiments, are viewed as intended to be combinable, unless the context clearly dictates otherwise.

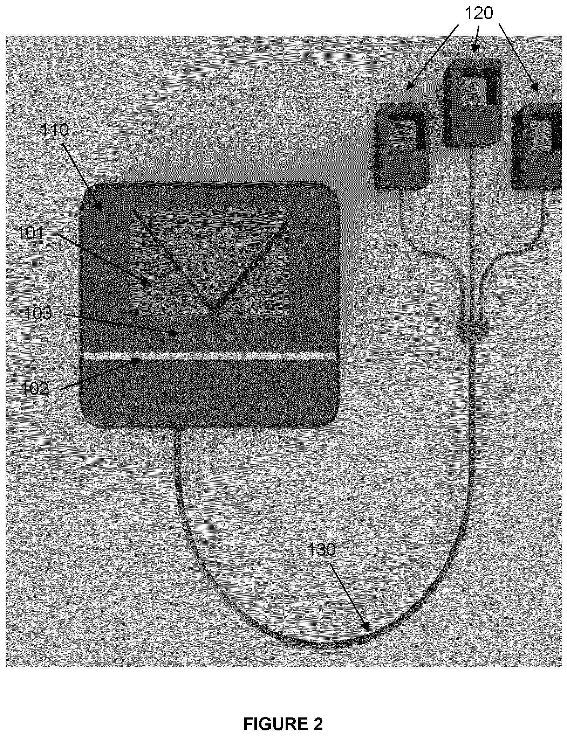

In one embodiment, as illustrated in Figure 2, the device 100 for measuring electrical parameters of an electrical installation comprises: a control unit; electromagnetic current and voltage sensors 120 associated with the electrical installation, adapted to transform the sensed current and voltage into electrical signals processable by the measuring device 100; and a non-volatile data storage memory.

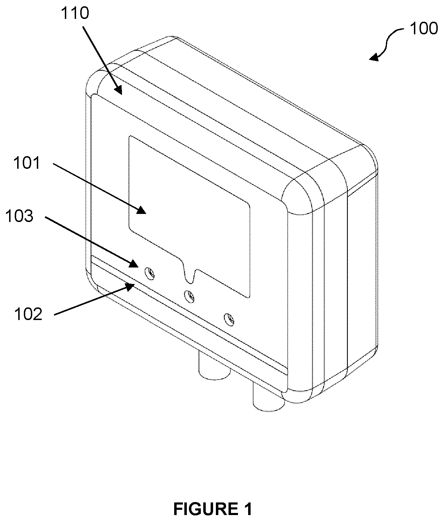

In another embodiment, the device 100 further comprises a data transmission and reception module, a geolocation system, at least one presence sensor; an LCD screen 101, at least one LED 102, and at least one button 103, as shown in Figure 1. The device further comprises means for detecting fraud in its operation and installation.

The control unit is adapted to measure electrical parameters of the electrical installation by acquiring processable electrical signals and storing a history of the measurements in the non-volatile data storage memory.

The control unit is further adapted to transmit data (e.g. the measurement history) through the data transmission and reception module to a control center. In one embodiment, the communication protocol of the data transmission and reception module is based on at least one of: 4G, 2G, Wi-Fi, low energy Bluetooth, LPWAN radio, Nb-loT, CatM, and RS-485 connection. The smart device 100 of the present invention represents a significant evolution over traditional meters, enabling more efficient and transparent management of the grid's electrical parameters. Such device 100 not only measures the amount of energy consumed but also records data at regular intervals, providing detailed information on energy usage over time. This data is sent in real time to the control center, enabling rapid detection of grid problems, optimization of energy distribution, and implementation of dynamic tariffs, offering consumers greater control over their energy consumption and the possibility of saving through more efficient use of electricity.

The electrical parameters of the electrical installation measured by the device 100 comprise, but are not limited to, one or more of: voltage, current, active power, reactive power, apparent power, energy consumed, phase angle, frequency, harmonic distortions up to the 32nd harmonic and current flow. The parameters transmitted to the control center are used by the control center, alone or in conjunction with other data from other sources, to inform a user of the energy consumption history, energy consumption profile of the electrical installation, monetary expenditure on the consumption of electrical energy, predictions of energy consumption and/or monetary expenditure, energy quality, among others. Optionally, such information may also be displayed on the device itself, via the LCD screen 101, which the user interacts with via at least one button 103. In this embodiment, the LCD screen 101 and the at least one LED 102 are also used to guide the installer during the installation and/or maintenance process of the device 100. Via the at least one button 103, the installer may interact with instructions displayed on the LCD screen 101.

The electrical parameters of the electrical installation may also be transmitted to other equipment, preferably but not limited to other equipment available in the same electrical installation. For example, when the electrical installation has a distributed generation system (a photovoltaic system, for example), device 100, through the measured electrical parameters, can identify the energy flow (from the electrical grid to the electrical installation, or from the electrical installation to the electrical grid) and communicate this to the distributed generation system, thus optimizing the use of the generated energy and avoiding disruptions to the electrical grid, improving its stability and protecting its infrastructure.

The device 100 includes means for protecting and detecting inclement weather conditions in the electrical installation. For example, in one embodiment, device 100 is capable of detecting current leakage in the neutral of the electrical installation through indirect, isolated measurement.

The device 100 comprises the geolocation module and the presence sensor, in which the control unit is configured to store in the non-volatile data storage memory and transmit to the control center, through the data transmission and reception module, a history of data relating to the geolocation of the device 100 and/or a history of data relating to the activation of the presence sensor. The geolocation system is based on at least one of GPS, GNSS, cellular antenna triangulation, and Wi-Fi signal trilateration, while the presence sensor is a millimeter wave emission and reception sensor for detecting interaction or maintenance events of the device 100. The device 100 also includes an auto-shutdown sensor for protection against overheating, increasing the useful life of the device 100.

The non-volatile data storage memory of the device 100 is capable of storing long-term data regarding the electrical parameters of the electrical installation, geolocation, presence sensor, or any other measured signal, which enables, for example, the storage of a measurement history of up to 12 months. However, it will be apparent to those skilled in the art that in alternative embodiments, the memory enables the storage of a measurement history of more than 12 months.

In any of the embodiments described herein, all components of device 100 are located within a main housing 110, with the exception of the electromagnetic current and voltage sensors 120, which are external to the main housing 110 and are connected to the main housing via a main cable 130, as shown in Figure 2. This configuration allows for greater versatility in its installation, giving the installer the freedom to position device 100 wherever is most appropriate depending on the location of the electrical installation, in addition to facilitating organization due to the presence of the main cable 130 that protects and does not expose the other wires of the electromagnetic sensors 120. The main housing 110 is constructed of ABS (Acrylonitrile Butadiene Styrene) plastic or polycarbonate injected with flame retardant and antiultraviolet additives.

The electromagnetic sensors 120 are current sensors and mains voltage sensors, such as a current transformer CT and a potential transformer VT. The current transformer CT is used to convert electrical current, which can be high and dangerous, into a lower magnitude signal that is safe for electronic processing.

The current transformer (CT) operates on the principle of magnetic induction, creating a smaller secondary current proportional to the primary current. Conversely, the potential transformer (PT) reduces the line voltage to a more manageable value that can be safely measured by the meter's internal circuitry. These electromagnetic sensors 120 ensure that both voltage and current values are accurately converted to levels that the electronic circuitry of the device 100 can process without risk of damage or reading errors. These current and voltage signals are then fed to a data acquisition circuit controlled by a microcontroller and a DSP digital signal processor.

This circuit amplifies and conditions the signals received from the sensors for better analysis, in addition to digitizing these analog signals using an analog-to-digital converter, which transforms these signals into digital formats that can be manipulated mathematically. After processing, the microcontroller executes complex algorithms to calculate instantaneous power by multiplying the digitized current and voltage samples. From these instantaneous power measurements, the total energy consumption is calculated by integrating these values over time, a task that the microcontroller manages continuously.

Thus, it is concluded that the embodiments and details of the invention can be varied considerably from what has been described and illustrated purely by way of non-limiting example, without departing from the scope of protection of the present invention as defined by the following claims.

## Claims

1. An ELECTRICAL PARAMETER MEASURING DEVICE (100) of an electrical installation, comprising:
- a control unit;
- electromagnetic current and voltage sensors (120) associated with the electrical installation, adapted to transform the sensed current and voltage into electrical signals that can be processed by the measuring device (100); and
- a data storage memory;
- the control unit being adapted to:
- measure electrical parameters of the electrical installation from the acquisition of processable electrical signals; and
- store a history of the measurements in the data storage memory.

2. The ELECTRICAL PARAMETER MEASURING DEVICE (100), according to claim 1, wherein the control unit transmits the measurement history through a data transmission and reception module to a control center.

3. The ELECTRICAL PARAMETER MEASURING DEVICE (100), according to any one of claims 1 to 2, wherein the electrical parameters comprise one or more of: voltage, current, active power, reactive power, apparent power, energy consumed, phase angle, frequency, harmonic distortions up to the 32^{nd} harmonic and the current flow.

4. The ELECTRICAL PARAMETER MEASURING DEVICE (100), according to any one of claims 1 to 3, wherein the control unit, through the electromagnetic sensors (120), is capable of detecting current leakage in the neutral of the electrical installation through indirect, isolated measurement.

5. The ELECTRICAL PARAMETER MEASURING DEVICE (100), according to any one of claims 2 to 4, comprising a geolocation module and a presence sensor, in which the control unit is configured to store in the data memory and transmit to the control center, through the data transmission and reception module, a history of data relating to the geolocation of the device (100) and a history of data relating to the activation of the presence sensor.

6. The ELECTRICAL PARAMETER MEASURING DEVICE (100), according to any one of claims 1 to 5, wherein the communication protocol of the data transmission and reception module is based on at least one of: 4G, 2G, Wi-Fi, low energy Bluetooth, LPWAN radio, Nb-loT, CatM and RS-485 connection.

7. The ELECTRICAL PARAMETER MEASURING DEVICE (100), according to any one of claims 5 to 6, wherein the geolocation system is based on at least one signal from: GNSS, cellular antenna triangulation and Wi-Fi signal trilateration.
